# EUROPEAN PATENT SPECIFICATION

(11) **EP 1 304 767 B1**
(45) Date of publication and mention of the grant of the patent: **04.04.2007**
(21) Application number: 02023304.5
(22) Date of filing: 17.10.2002
(51) Int. Cl.: H01R 12/24, H01R 12/38

(54) **Flexible circuit board connecting device**
Verbindungsanordnung für eine flexibele Leiterplatte
Dispositif de connexion pour un circuit flexible

(30) Priority: 18.10.2001 JP 2001321043
(43) Date of publication of application: 23.04.2003
(73) Proprietor: HIROSE ELECTRIC CO., LTD., Shinagawa-ku Tokyo (JP)
(72) Inventor: Matsuo, Tsutomu, c/o Hirose Electric Co., Ltd., Tokyo (JP)
(74) Representative: Pätzold, Herbert

(56) References cited:
- EP-A- 0 742 605
- US-A- 3 701 071
- US-A- 3 989 336
- US-A- 4 778 403
- US-A- 5 839 916

## Description

The present invention relates to a technology of an electrical connector, particularly, to a mechanism to connect a flexible circuit board to a connector.

A flexible circuit board is comprised of a flexible board, wirings provided on the flexible board and connection pads to be conductive through wirings, which are provided on the edge of the flexible board. When the flexible circuit board is used, it is placed onto a flat type connector, and then pressed and held, so that the connection pads contact with corresponding terminals of the connector. Such connection structure is known, for example, by disclosures in Japanese Unexamined Patent Publications Nos. 8-255961, 8-227745 and 3-182075.

In this type of connectors, the flexible circuit board or the connector has a flat connecting section (e.g. connection pad), and the other, the one between the flexible board and the connector which does not have the flat connect section, has a protruding elastic contact section. By putting in place and then pressing the flexible circuit board and the connector, such that the protruding elastic contact section is pressed to/into the flat contact section, the connection between the flexible circuit board and the connector is achieved and maintained. Therefore, the connection is achieved without an inserting force for engagement, such as the one required for the connection of terminals of normal connector. Also, since the terminals are arranged in columns and rows in those methods, the contact points to prevent the inserting force from becoming too large.

In such publicly known devices, a pressuring member is used to press the flexible circuit board towards the connector. According to the mechanism of the pressuring member, it is difficult to press the whole area of the connecting section of the flexible circuit board by the pressuring member to connect with the connector. Therefore, the pressuring member merely presses locally, for example, on both edges.

Since the flexible circuit board is flexible itself, it causes a distortion, such as deflection or torsion, if it is locally pressed. In other words, the connecting pressure is not uniformly applied to an area of the connecting section, which causes poor connection or the like, so that its electrical properties become unstable. Those problems are more conspicuously observed for flexible circuit boards having a large number of connection pads (contact points).

Accordingly, it is an object of the present invention to provide a structure for the connection of the flexible circuit, board, which enables uniform and stable connection without such problems even when the flexible circuit board has a large number of contact points.

The prior art US-A-6 083 022, a system for connecting daughter and mother boards, discloses a base securely mounted on the mother board and a cover horizontally slidably attached to the base. A plurality of passageways obliquely extend through the cover for receiving a corresponding number of contacts wherein the bottom of each contact projects out of the cover.

In view of the above prior art US A-6 083 022 it is a further object of the present invention to provide a flexible board connecting device whereby the connecting pressure is uniformly applied and the distortion such as deflection or torsion of the flexible board is avoided.

The above objects are solved by the invention as claimed in claim 1.

The embodiments of the invention will now be described with reference to the accompanying drawings, in which

Fig. 1 is a top plan view of the flexible circuit board according to the first embodiment of the present invention.

Figs. 2(A), (B), and (C) are sectional views of the connector in the first embodiment, illustrating the flow of the connecting process.

Figs. 3(A), (B) and (C) are sectional views of the flexible circuit board and the connector in the second embodiment of the invention, illustrating the flow of the connecting process.

Figs. 4(A), (B) and (C) are top views of the flexible circuit board and the connector in Fig. 3, illustrating the connecting process.

### First Embodiment

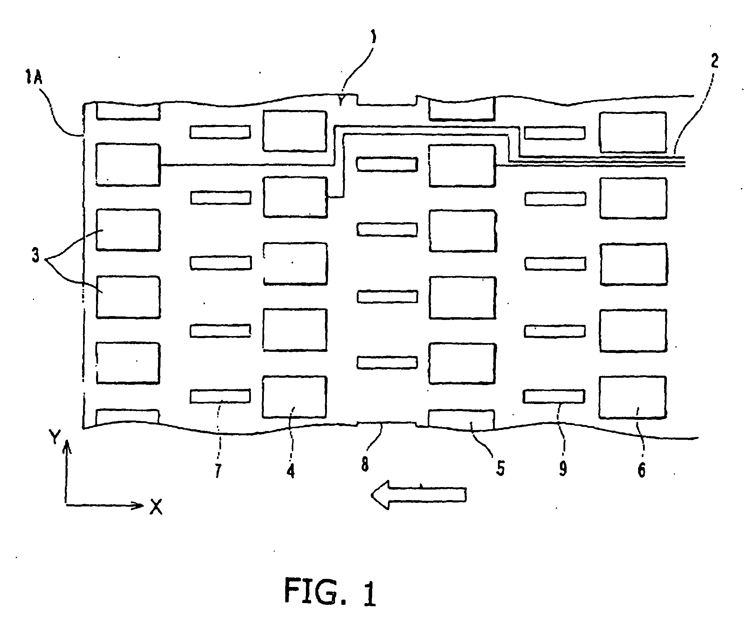

In Fig. 1, the flexible circuit board 1, which is on an XY plane, has a cable band having wirings 2 extending in the right direction (X direction). The flexible circuit board 1 has a plurality of first connection pads 3 provided in rows along Y direction, which is parallel to a front edge (an edge extending along Y direction at left edge of the flexible circuit board), with a certain pitch interval in proximity to the front edge 1A. Here, each first connection pad is comprised of an electrically conductive layer. The rows of pads, such as rows of second connection pads, third connection pads and fourth connection pads, are successively provided in similar manner to the first connection pads. The connection pads 4, 6 are arranged in the positions shifted for half pitch from the position of the connection pads 3, b respectively.

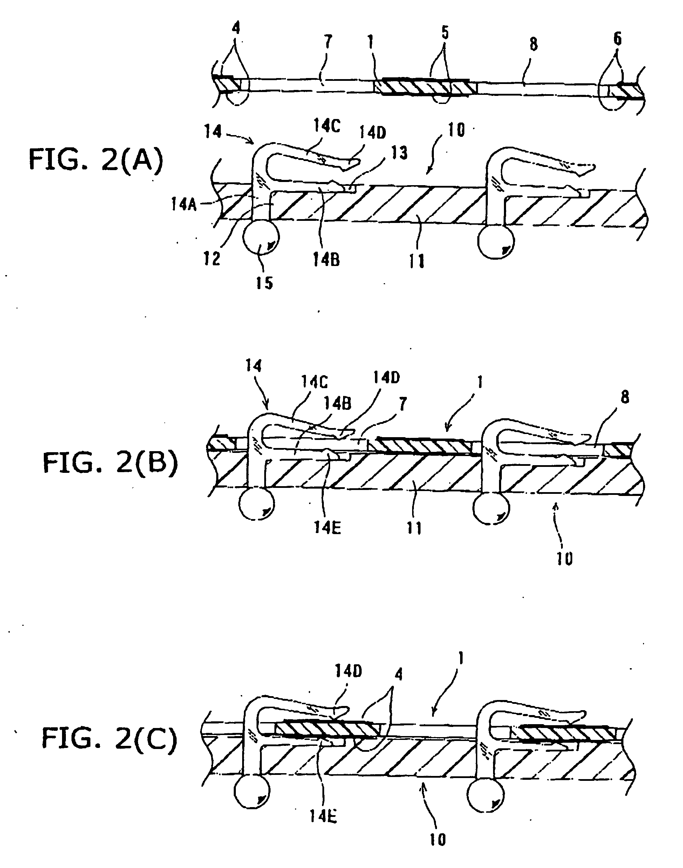

Long and narrow windows 7, 8, 9 are provided left of the connection pads 4, 5, 6 respectively. The interval between each connection pad and the window is substantially equal to the distance between the first connection pads 1 on the front row and the front edge of the flexible circuit board. The wiring conductors 2 extend rightward from each connection pad in respective row of connection pads 3, 4, 5, 6 in a manner not to interfere with the windows and the other pads. Since the wirings 2 are more densely arranged in right side, it can be suggested to arrange the wirings in multiple layers, where the insulating layer is placed between the wirings, so that the wirings would not be unnecessarily too densely arranged. In this embodiment, the connection pads 3, 4, 5, 6 and their wirings are provided on both surfaces of the flexible circuit board, as illustrated in Fig. 2, but it is not limited to this, and they can be provided only on one surface, for example only on the upper surface of the flexible circuit board.

On the other hand, the connector 10 is also on XY plane corresponding to the flexible circuit board. As illustrated in Fig. 2, the connector 10 is comprised of a flat housing 11. Here, the holding hole 12 goes through the housing and a long and narrow holding slot 13 is provided on the upper surface of the housing and links to the holding hole 12. The terminal 14 is prepared by punching a metal sheet maintaining its flat surface parallel to the surface of the paper of the figure, and pressed into the holding hole 12. As illustrated in Fig. 2, the terminal 14 has a fixing section 14A, which is the connection section to be pressed into the holding hole 12, a holding arm 14B, which defines the position to press in and is held by the holding slot 13, and an elastic arm 14C expending parallel to the holding arm 14B. The protruding contact sections 14D, 14E are formed at front ends of the elastic arm 14C and the holding arm 14B, respectively. The terminal 14 are provided corresponding to connection pads 3, 4, 5, 6 of the flexible circuit board 1, and the elastic arm 14C has such thickness and length as to link through the windows 7, 8, 9 of the flexible circuit board 1 when the windows 7, 8, 9 are placed onto the corresponding terminals. The terminal has a sphere-shaped solder ball, which is provided at the lower end of the fixing section 14A, and protrudes from the lower surface of the housing 11.

In this embodiment, the connector is connected to the flexible circuit board according to the following steps.
(1) First, connect the connector 10 to a specified connecting member such as a circuit board (not shown). The connection between the connector 10 and the circuit board is achieved by placing the connector 10 onto a specific position on the circuit board, and then connecting the terminal 14 and the corresponding circuit section via soldering by melting the solder ball 14 with hot air or the like.
(2) As illustrated in Fig. 2(A), bring the flexible circuit board 1 over to the corresponding position on the upper side of the connector 10.
(3) In next, place the flexible circuit board onto the connector 10, such that they contact each other over the surface. The elastic arm 14C of the terminal 14 protrude from the corresponding windows 7, 8, 9 without any resistance (See Fig. 2(B)).
(4) Thereafter, move the flexible circuit board 1 leftward. The contact section 14D provided at front end of the elastic arm 14 moves onto the front edge 1A of the flexible circuit board 1 and then onto the edge of each window 7, 8, 9. After that, the contact section 14D moves onto the corresponding connection pad 3, 4, 5, 6. By doing this, the contact sections 14D, 14E contact with the connection pads 3, 4, 5, 6 by elastic pressure, in a manner that the connection pads are tightly pressed by the elastic recovery force of the elastic arm 14.

### Second Embodiment

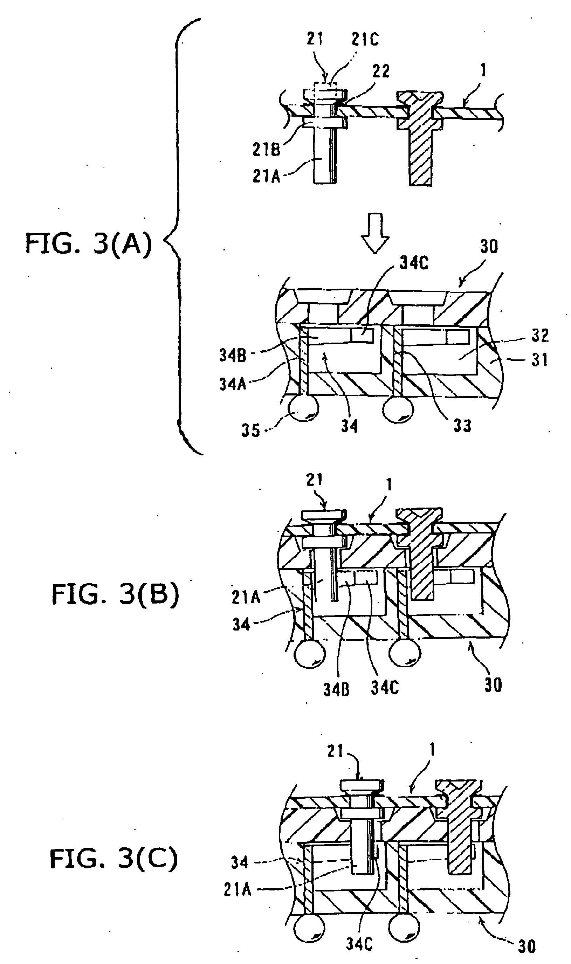

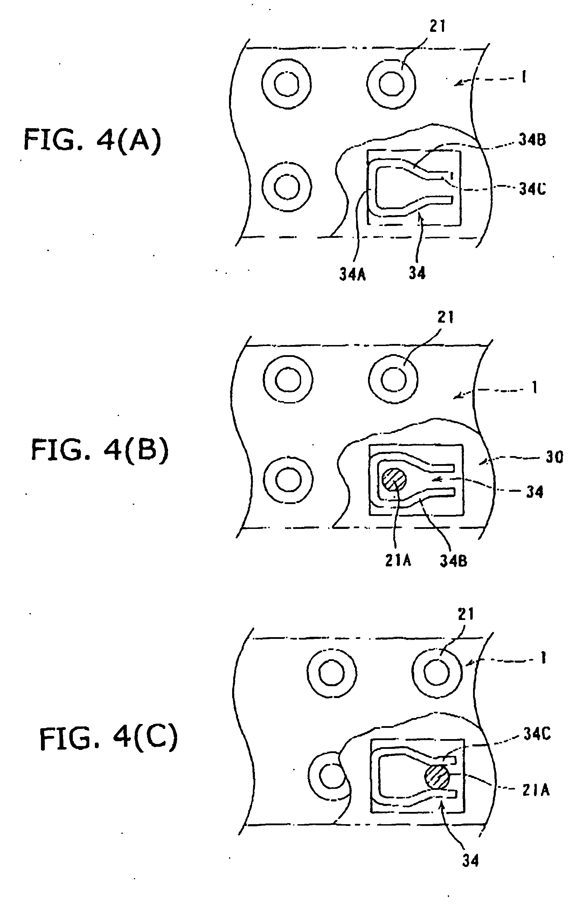

The second embodiment is described below with respect to Figs. 3 and 4. In this embodiment, the flexible circuit board 1 does not have the window as in the previous embodiment, but has a plurality of contact pins 21. The electrically conductive layers 22 are formed on the flexible circuit board 1, corresponding to the positions of the connection pads. The electrically conductive layers 22 arc provided around holes for inserting the contact pins 21 on both upper and lower surfaces of the flexible circuit board, and also provided on the inner surfaces of cylindrical portions of the holes, such that the conductive layer is continuously provided around the holes from the upper surface through the lower surface.

The contact pin 21 has a shaft 21A, a flange 21B and a head part 21C having substantially same diameter as that of the shaft 21 (double-dashed line in Fig. 3(A)). To mount the contact pin 21 to the flexible circuit board 1, the protruding head part 21C is inserted through the hole from the bottom. Then, the head part 21C is deformed though plastic deformation so as to shape like a flange (see Fig. 3(A) for its sectional view). That is, the diameter of the head part 21C is broadened by pressing the head part in the axial direction with an appropriate tool.

On the other hand, as illustrated in Fig. 3, the connector 30 has a relatively thick flat housing 31 in comparison with the one in the previous embodiment. In this embodiment, the housing 31 has a dent 32 opening upward on its surface and a holding hole 33 which is located at edge of the dent and goes through to the lower surface of the housing.

As shown in Figs. 3 and 4, the terminal 34 has a fixing section 34A, which is a flat type connection section pressed into the holding hole 33, and a U-shape elastic arm piece 34B which consists of two facing arms in the dent 32. The U-shape elastic arm piece 34B is provided at the upper portion of the fixing section 34A, and extends such that the U-shape elastic arm piece is angled from the direction of the fixing section 34A. The distance between the two facing arms of the U-shape elastic arm piece becomes shorter as it goes to the ends (free ends), and the contact section 34C is formed by those free ends. The distance between the two facing arms of the U-shape elastic arm piece 34B is designed such that the contact pin can well fit in, and simultaneously the spacing between the contact sections 34C is designed to be slightly smaller than the diameter of the shaft 21A of the contact pin 21A. Also, a solder ball 35 is provided on the lower end of the fixing section 34A, in a similar manner to that in the previous embodiment.

In this embodiment, to use the device, the terminal 34 is first connected with the specified circuit board using the solder ball 35. Thereafter, as illustrated in Fig. 3(A), the flexible circuit board is brought onto the connector 1, and then the contact pin 21 mounted to the flexible circuit board 1 is inserted with zero inserting force into the area on the connector, where the distance between the two facing arms of the U-shape arm piece 34B is large (see Figs. 3(A) and 4(B)). Then, the flexible circuit board is moved in a direction parallel to its surface, so that the contact pin 21 is pushed into the contact section 34C and the connection between the flexible circuit board and the connector is completed.

As described above, in the present invention, each terminal of the connector and its corresponding portion of the flexible circuit board are made to elastically contact simply by inserting the flexible circuit board with zero inserting force into a position very close to the connection section and then by relatively moving the flexible circuit board parallel to its surfaces. Therefore, the problem of uneven pressure over the contacting surface due to local application of pressure onto the flexible circuit board is solved, and same pressure is equally applied to any portion over the surface. Accordingly, the device of the present invention is very effective, especially when many terminals are arranged in lines and rows.

## Claims

1. A flexible circuit board connecting device, comprising:
a flat connector (10) to connect with a desired circuit member;
a flexible circuit board (1) which extends on an XY-plane to connect with said circuit member via said connector (10);
a flat housing (11) which extends two dimensionally on an XY-plane corresponding to said flexible circuit board (1);
a plurality of holding holes (12) provided in said housing (11); and
a plurality of terminals (14) held in said holding holes (12) of said flat housing, said terminals (14) each having a connection section provided on one side of said housing (11) to connect with said desired circuit member and a contact section (14D) to connect with said flexible circuit board (1) on the other side of said housing, and
said flexible circuit board (1) and said contact section (14D) of said terminal (14) are movable relative to each other in a direction parallel to a surface of said flexible circuit board (1) from a zero inserting force position, where said flexible circuit board (1) comes into contact with said connector (10) with zero inserting force, to a contact position, where said flexible circuit board (1) contacts said connector under pressure;
**characterized in that**
said terminals each having an elastic arm (14C) protruding from other side of said housing (11) and extending along said other side;
a window (7,8,9) formed in said flexible circuit board (1) to receive said elastic arm (14C) at said zero inserting force position; and
a connection pad (3,4,5,6) provided on a surface near said window (7,8,9), wherein said contact section (14D) of said connector is provided on said elastic arm, and
said contact section (14D) elastically contacts with said connection pad (3,4,5,6) when said flexible circuit board (1) is moved relatively to said contact position

2. A flexible circuit board connecting device according to claim 1, wherein said terminal (14) has another arm provided to tightly press said flexible circuit board (1) by moving in concert with said elastic arm (14C).

3. A flexible circuit board connecting device according to one of claims 1 through 3, wherein said connection pad (3,4,5,6), window (7,8,9) and their corresponding terminal of said connector (10) are arranged in columns and rows.

4. A flexible circuit board connecting device according to claim 1, wherein said flexible circuit board (1) has a contact pin (21) protruding from a surface of said flexible circuit board (1) towards said connector (10) to connect with said terminal (14) of said connector (10), and said contact pin (21) is mowable into said holding hole (12) of said connector(10) by said zero inserting force and contacts with said contact section (14D) of said terminal(14) by pressure through the movement towards said contact position.

5. A flexible circuit board connecting device according to claim 4, wherein said terminal (14) of said connector (10) is made to tightly press said contact pin (21).

6. A flexible circuit board connecting device according to claim 5, wherein said contact pin (21) of said flexible circuit board (1) and its corresponding terminal of said connector (10) are arranged in columns and in row.

## Patentansprüche

1. Verbindungsanordnung für eine flexible Leiterplatte, mit:
ein flacher Verbinder (10) zur Verbindung mit einem vorbestimmten Schaltkreiselement;
eine flexible Leiterplatte (1), die sich auf einer XY-Ebene erstreckt, zur Verbindung des Schaltkreiselements mit dem Verbinder (10);
ein flaches Gehäuse (11) erstreckt sich 2-dimensional auf einer XY-Ebene, die mit der flexiblen Leiterplatte (1) korrespondiert;
in dem Gehäuse (11) sind eine Vielzahl von Haltelöchern (12) vorgesehen, und
eine Vielzahl von Anschlüsse (14) sind in den Haltelöchern (12) des flachen Gehäuses gehalten, und die Anschlüsse (14) haben jeweils einen Verbindungsabschnitt an einer Seite des Gehäuses (11) zur Verbindung mit dem vorbestimmten Schaltkreiselement und einen Kontaktabschnitt (14D) auf der anderen Seite des Gehäuses zur Verbindung mit der flexiblen Leiterplatte (1), und
die flexible Leiterplatte (1) und der Kontaktabschnitt (14D) des Anschlusses (14) sind relativ zueinander parallel zu einer Oberfläche der flexiblen Leiterplatte (1) verschiebbar, und zwar von einer Null-Einsatz-Kraft Position, bei der die flexible Leiterplatte (1) ohne Einsatzkraft Kontakt mit dem Verbinder (10) bekommt, zu einer Kontakt-Position, bei der die flexible Leiterplatte (1) unter Druck Kontakt mit dem Verbinder bekommt;
**dadurch gekennzeichnet, dass**
die Anschlüsse haben jeweils einen elastischen Arm (14C), der aus der anderen Seite des Gehäuses (11) herausragt und sich entlang der anderen Seite erstreckt; ein Fenster (7,8,9) ist in der flexiblen Leiterplatte (1) ausgebildet zum Empfang des elastischen Arms (14C) bei der Null-Einsatz-Kraft Position; und
ein Verbindungs-Pad (3,4,5,6) ist auf einer Oberfläche in der Nähe des Fensters (7,8,9) vorgesehen, wobei der Kontaktabschnitt (14D) des Verbinders auf dem elastischen Arm vorgesehen ist, und der Kontaktabschnitt (14D) elastischen Kontakt mit dem Verbindungs-Pad (3,4,5,6) hat, wenn die flexible Leiterplatte (1) relativ zu der Kontakt-Position verschoben wird.

2. Flexible Leiterplatte nach Anspruch 1, wobei der Anschluss (14) einen anderen Arm hat zum festen Druck der flexiblen Leiterplatte (1) durch Bewegung im Zusammenspiel mit dem elastischen Arm (14C).

3. Flexible Leiterplatte nach einem der Ansprüche 1 und 2, wobei der Verbindungs-Pad (3,4,5,6), das Fenster (7,8,9) und die jeweiligen Anschlüsse des Verbinders (10) in Spalten und Reihen angeordnet sind.

4. Flexible Leiterplatte nach Anspruch 1, wobei die flexible Leiterplatte (1) einen Kontaktstift (21) hat, der sich von einer Oberfläche der flexiblen Leiterplatte (1) zu dem Verbinder (10) erstreckt, zur Verbindung mit dem Anschluss (14) des Verbinders (10), und der Kontaktstift (21) ist in dem Gehäuse (12) des Verbinders (10) bei der Null-Einsatz-Kraft und hat Kontakt mit dem Kontaktabschnitt (14D) des Anschlusses (14) hat durch die Bewegung in Richtung zu der Kontakt-Position.

5. Flexible Leiterplatte nach Anspruch 4, wobei der Anschluss (14) des Verbinders (10) durch festen Druck des Kontaktstifts (21) bereitgestellt ist.

6. Flexible Leiterplatte nach Anspruch 5, wobei der Kontaktstift (21) der flexiblen Leiterplatte (1) und der korrespondierende Anschluss des Verbinders (10) in Spalten und Reihen angeordnet sind.

## Revendications

1. Dispositif de connexion de circuit flexible, comprenant:
un connecteur plat (10) pour connecter un élément de circuit souhaité ;
un circuit flexible (1) qui s'étend sur un plan XY pour connecter ledit élément de circuit par le biais dudit connecteur (10);
un boîtier plat (11) qui s'étend de manière bidimensionnelle sur un plan XY correspondant au dit circuit flexible (1) ;
une pluralité de trous de maintien (12) disposés dans ledit boîtier (11) ; et
une pluralité de bornes (14) maintenues dans lesdits trous de maintien (12) dudit boîtier plat, lesdites bornes (14) ayant chacune une section de connexion disposée sur une face dudit boîtier (11) à connecter au dit élément de circuit souhaité et une section de contact (14D) à connecter au dit circuit flexible (1) sur l'autre face dudit boîtier, et
ledit circuit flexible (1) et ladite section de contact (14D) de ladite borne (14) sont mobiles l'un par rapport à l'autre dans une direction parallèle à une surface dudit circuit flexible (1) depuis une position à force d'insertion nulle, où ledit circuit flexible (1) vient en contact avec ledit connecteur (10) à force d'insertion nulle, à une position de contact, où ledit circuit flexible (1) contacte ledit connecteur sous pression ;
**caractérisé en ce que**
lesdites bornes ayant chacune un bras élastique (14C) dépassant de l'autre face dudit boîtier (11) et s'étendant le long de ladite autre face ;
une fenêtre (7, 8, 9) formée dans ledit circuit flexible (1) afin de recevoir ledit bras élastique (14C) en une position à force d'insertion nulle ; et une plage d'accueil de connexion (3, 4, 5, 6) disposée sur une surface proche de ladite fenêtre (7, 8, 9), dans lequel ladite section de contact (14D) dudit connecteur est disposée sur ledit bras élastique, et ladite section de contact (14D) est en contact de manière élastique avec ladite plage d'accueil de connexion (3, 4, 5, 6) lorsque ledit circuit flexible (1) est déplacé relativement à ladite position de contact.

2. Dispositif de connexion de circuit flexible selon la revendication 1, dans lequel ladite borne (14) a un autre bras disposé pour exercer une pression ferme sur ledit circuit flexible (1) en bougeant de concert au dit bras élastique (14C).

3. Dispositif de connexion de circuit flexible selon l'une des revendications 1 à 2, dans lequel lesdites plage d'accueil de connexion (3, 4, 5, 6), fenêtre (7, 8, 9) et leur borne correspondante dudit connecteur (10) sont placées selon des colonnes et des rangées.

4. Dispositif de connexion de circuit flexible selon la revendication 1, dans lequel ledit circuit flexible (1) à une broche de contact (21) dépassant d'une surface dudit circuit flexible (1) en direction dudit connecteur (10) afin de connecter ladite borne (14) dudit connecteur (10), et ladite broche de contact (21) est mobile dans ledit trou de maintien (12) dudit connecteur (10) à ladite force d'insertion nulle et est en contact avec ladite section de contact (14D) de ladite borne (14) par pression suite au mouvement vers ladite position de contact.

5. Dispositif de connexion de circuit flexible selon la revendication 4, dans lequel ladite borne (14) dudit connecteur (10) est faite pour exercer une pression ferme sur ladite broche de contact (21).

6. Dispositif de connexion de circuit flexible selon la revendication 5 dans lequel ladite broche de contact (21) dudit circuit flexible (1) et sa borne correspondante dudit connecteur (10) sont placées selon des colonnes et des rangées.
